# EUROPÄISCHE PATENTANMELDUNG

(11) **EP 0 989 603 A2**
(43) Veröffentlichungstag der Anmeldung: **29.03.2000**
(21) Anmeldenummer: 99118738.6
(22) Anmeldetag: 22.09.1999
(51) Int. Cl.: H01L 21/8242, H01L 27/108

(54) **Grabenkondesator mit Isolationskragen und entsprechendes Herstellungsverfahren**

(30) Priorität: 23.09.1998 DE 19843641
(71) Anmelder: SIEMENS AKTIENGESELLSCHAFT, 80333 München (DE)
(72) Erfinder: Heineck, Lars-Peter, 75012 Paris (FR); Jacobs, Tobias, 75012 Paris (FR)

(57) **Zusammenfassung**

Die vorliegende Erfindung schafft einen Grabenkondensator, insbesondere zur Verwendung in einer Halbleiter-Speicherzelle, mit einem Graben (100), der in einem Substrat (10) gebildet ist; einem im Substrat (10) vorgesehenen Bereich als erste Kondensatorplatte; einem Isolationskragen (110), der im oberen Bereich des Grabens (100) gebildet ist; einer dielektrischen Schicht (60) auf der Grabenwand als Kondensatordielektrikum; und einem in den Graben (100) gefüllten leitenden Füllmaterial (50) als zweite Kondensatorplatte; wobei die dielektrische Schicht (60) den Isolationskragen (110) zumindest teilweise umgibt. Ebenfalls schafft die Erfindung ein entsprechendes Herstellungsverfahren.

## Beschreibung

Die vorliegende Erfindung betrifft einen Grabenkondensator mit einem Isolationskragen und ein entsprechendes Herstellungsverfahren.

Integrierte Schaltungen (ICs) oder Chips verwenden Kondensatoren zum Zwecke der Ladungsspeicherung. Ein Beispiel eines IC, welcher Kondensatoren zum Speichern von Ladungen verwendet, ist ein Speicher-IC, wie z.B. ein Chip für einen dynamischen Schreib-/Lesespeicher mit wahlfreiem Zugriff (DRAM). Der Ladungszustand ("0" oder "1") in dem Kondensator repräsentiert dabei ein Datenbit.

Ein DRAM-Chip enthält eine Matrix von Speicherzellen, welche in Form von Zeilen und Spalten verschaltet sind. Üblicherweise werden die Zeilenverbindungen als Wortleitungen und die Spaltenverbindungen als Bitleitungen bezeichnet. Das Auslesen von Daten von den Speicherzellen oder das Schreiben von Daten in die Speicherzellen wird durch die Aktivierung geeigneter Wortleitungen und Bitleitungen bewerkstelligt.

Üblicherweise enthält eine DRAM-Speicherzelle einen mit einem Kondensator verbundenen Transistor. Der Transistor enthält zwei Diffusionsbereiche, welche durch einen Kanal getrennt sind, oberhalb dessen ein Gate angeordnet ist. Abhängig von der Richtung des Stromflusses bezeichnet man den einen Diffusionsbereich als Drain und den anderen als Source. Die Bezeichnungen "Drain" und "Source" werden hier hinsichtlich der Diffusionsbereiche gegenseitig austauschbar verwendet. Die Gates sind mit einer Wortleitung verbunden, und einer der Diffusionsbereiche ist mit einer Bitleitung verbunden. Der andere Diffusionsbereich ist mit dem Kondensator verbunden. Das Anlegen einer geeigneten Spannung an das Gate schaltet den Transistor ein, ermöglicht einen Stromfluß zwischen den Diffusionsbereichen durch den Kanal, um so eine Verbindung zwischen dem Kondensator und der Bitleitung zu bilden. Das Ausschalten des Transistors trennt diese Verbindung, indem der Stromfluß durch den Kanal unterbrochen wird.

Die in dem Kondensator gespeicherte Ladung baut sich mit der Zeit aufgrund eines inhärenten Leckstroms ab. Bevor sich die Ladung auf einen unbestimmten Pegel (unterhalb eines Schwellwerts) abgebaut hat, muß der Speicherkondensator aufgefrischt werden.

Das fortlaufende Bestreben nach Verkleinerung der Speichervorrichtungen fördert den Entwurf von DRAMs mit größerer Dichte und kleinerer charakteristischer Größe, d.h. kleinerer Speicherzellenfläche. Zur Herstellung von Speicherzellen, welche eine geringeren Oberflächenbereich besetzen, werden kleinere Komponenten, beispielsweise Kondensatoren, verwendet. Jedoch resultiert die Verwendung kleinerer Kondensatoren in einer erniedrigten Speicherkapazität, was wiederum die Funktionstüchtigkeit und Verwendbarkeit der Speichervorrichtung widrig beeinflussen kann. Beispielsweise erfordern Leseverstärker einen ausreichenden Signalpegel zum zuverlässigen Auslesen der Information in den Speicherzellen. Das Verhältnis der Speicherkapazität zur Bitleitungskapazität ist entscheidend bei der Bestimmung des Signalpegels. Falls die Speicherkapazität zu gering wird, kann dieses Verhältnis zu klein zur Erzeugung eines hinreichenden Signals sein. Ebenfalls erfordert eine geringere Speicherkapazität eine höhere Auffrischfrequenz.

Ein Kondensatortyp, welcher üblicherweise in DRAMs verwendet wird, ist ein Grabenkondensator. Ein Grabenkondensator hat eine dreidimensionale Struktur, welche in dem Siliziumsubstrat ausgebildet ist. Eine Erhöhung des Volumens bzw. der Kapazität des Grabenkondensators kann durch tieferes Ätzen in das Substrat erreicht werden. In diesem Fall beweirkt die Steigerung der Kapazität des Grabenkondensators keine Vergrößerung der von der Speicherzelle belegte Oberfläche.

Ein üblicher Grabenkondensator enthält einen in das Substrat geätzten Graben. Dieser Graben wird typischerweise mit p⁺- oder n⁺-dotiertem Polysilizium gefüllt, welches als eine Kondensatorelektrode dient (auch als Speicherkondensator bezeichnet). Die zweite Kondensatorelektrode ist das Substrat oder eine "vergrabene Platte". Ein Kondensatordielektrikum, welches z.B. Nitrid enthält, wird üblicherweise zur Isolation der zwei Kondensatorelektroden verwendet.

In dem oberen Bereich des Grabens wird ein dielektrischer Kragen (vorzugsweise ein Oxidbereich) erzeugt, um einen Leckstrom zu verhindern bzw. den oberen Teil des Kondensators zu isolieren.

Das Kondensatordielektrikum wird in dem oberen Bereich des Grabens, wo der Kragen zu bilden ist, üblicherweise vor dessen Bildung entfernt, da dieser obere Teil des Kondensatordielektrikums für nachfolgende Prozeßschritte hinderlich ist.

Insbesondere wird dadurch die Gate-Leiterbahn-Ätzung erschwert, da das Kondensatordielektrikum Teile des vorher abgeschiedenen Gate-Polysiliziums von der Ätzung abschirmt, was eine Kurzschlußgefahr zwischen der Gate-Leiterbahn und dem Grabenkondensator mit sich bringt.

Weiterhin wird die Integration der Brücke zum Transistor wesentlich erschwert, wenn das Kondensatordielektrikum an der Grabenseitenwand erhalten bleibt. In diesem Fall ist die Kontaktfläche zum Drain-Diffusionsgebiet des Transistors stark reduziert, was einen erhöhten Übergangswiderstand und entsprechende Folgeprobleme für den Speicherbetrieb mit sich bringt.

Schließlich fördert abstehendes Kondensatordielektrikum die Störstellen- und Versetzungsbildung, und z.B. Pinholes bzw. Nadellöcher werden leicht am Übergang zwischen dem unteren Teil des Kragens und dem oberen Teil des Kondensatordielektrikums bei den nachfolgenden Hochtemperaturprozessen gebildet. Solche Fehlstellen verschlechtern die Qualität des Kondensatordielektrikums und sind eine wesentliche Quelle für den Ladungsabbau aus dem Graben. Dies reduziert die Haltezeit des Grabenkondensators und beeinträchtigt somit seine Funktionstüchtigkeit.

Um diesen Problemen aus dem Wege zu gehen, sollte der obere Teil des Kondensatordielektrikums entfernt werden, jedoch nur soweit, wie unbedingt nötig, da das Kondensatordielektrikum vorteilhafterweise auch als Isolator und Diffusionsbarriere dient.

Daher ist es Aufgabe der vorliegenden Erfindung, einen verbesserten Grabenkondensator mit einem Isolationskragen zu schaffen, bei dem das Kondensatordielektrikum nur bis zur nötigen Tiefe, und nicht über die gesamte Tiefe des Kragens entfernt ist. Eine weitere Aufgabe der Erfindung besteht in der Bereitstellung eines entsprechenden Herstellungsverfahrens.

Erfindungsgemäß wird diese Aufgabe durch den in Anspruch 1 angegebenen Grabenkondensator mit einem Isolationskragen gelöst. Weiterhin wird diese Aufgabe durch das in Anspruch 5 angegebene Verfahren gelöst.

Bevorzugte Weiterbildungen sind Gegenstand der jeweiligen Unteransprüche.

Die der vorliegenden Erfindung zugrundeliegende Idee liegt darin, das Kondensatordielektrikum nur dort zu entfernen, wo unbedingt notwendig, also im Kondensatoranschlußbereich. Verfahrensbedingt kann es erforderlich sein, das Kondensatordielektrikum auch im Isolationsgrabenbereich zu entfernen. Diese Entfernung wird durch Einführung eines Isolationkragen-Ätzschritts nach dem Einsenken des zweiten Polysiliziums erreicht. Mit anderen Worten wird das Kondensatordielektrikum bzw. die ONO-Schicht dort entfernt, wo auch der ursprünglich aufgebrachte Isolationskragen, der vorzugsweise aus TEOS-Oxid besteht, entfernt wird, so daß die dielektrische Schicht den Isolationskragen zumindest teilweise umgibt.

Das erfindungsgemäße Verfahren weist gegenüber den bekannten Lösungsansätzen den Vorteil auf, daß durch die Durchführung des Isolationkragen-Ätzschritts nach dem Einsenken des zweiten Polysiliziums, also zu einem im Vergleich mit dem bekannten Verfahren späteren Zeitpunkt, erhebliche Kosten- und Zeitersparnisse verbunden sind. Auch werden Probleme an der Grenzfläche der beiden Polysiliziumfüllungen deutlich reduziert.

Ein wesentlicher Vorteil dieser Vorgehensweise ist die Beseitigung der Desintegration der aufeinanderfolgenden Prozesse Einsenkätzung des Polysiliziums, Kragenoxidabscheidung und Kragenätzung, wie sie beim üblichen Prozeß herrscht. Dadurch steigt die Prozeßgeschwindigkeit erheblich.

Ein Ausführungsbeispiel der vorliegenden Erfindung ist in den Zeichnungen dargestellt und wird in der nachfolgenden Beschreibung näher erläutert.

In den Figuren zeigen:
- Fig. 1a-f: die zum Verständnis der Erfindung wesentlichen Verfahrensschritte zur Herstellung eines Ausführungsbeispiels des erfindungsgemäßen Grabenkondensators; und
- Fig. 2a-f: die zum Verständnis der der Erfindung zugrundeliegenden Problematik wesentlichen Verfahrensschritte zur Herstellung eines üblichen Grabenkondensators.

Obwohl auf beliebige Grabenkondensatoren anwendbar, werden die vorliegende Erfindung und die ihr zugrundeliegende Problematik nachstehend in bezug auf einen in einer DRAM-Speicherzelle verwendeten Grabenkondensator erläutert. Solche Speicherzellen werden in integrierten Schaltungen (ICs), wie beispielsweise Speichern mit wahlfreiem Zugriff (RAMs), dynamischen RAMs (DRAMs), synchronen DRAMs (SDRAMs), statischen RAMs (SRAMs) und Nur-Lese-Speichern (ROMs) verwendet. Andere integrierte Schaltungen enthalten Logikvorrichtungen, wie z.B. programmierbare Logikarrays (PLAs), anwenderspezifische ICs (ASICs), Mischlogik/ Speicher-ICs (eingebettete DRAMs) oder sonstige Schaltungsvorrichtungen. Üblicherweise wird eine Vielzahl von ICs auf einem Halbleitersubstrat, wie z.B. einem Siliziumwafer, parallel hergestellt. Nach der Verarbeitung wird der Wafer zerteilt, um die ICs in eine Vielzahl individueller Chips zu separieren. Die Chips werden dann in Endprodukte verpackt, beispielsweise zur Verwendung in Verbraucherprodukten, wie z.B. Computersystemen, zellulären Telefonen, persönlichen digitalen Assistenten (PDAs) und weiteren Produkten. Zu Diskussionszwecken wird die Erfindung hinsichtlich der Bildung einer einzelnen Speicherzelle beschrieben.

Eine Beschreibung der Herstellung eines üblichen, in einem einstufigen Ätzprozeß hergestellten Grabenkondensators für eine DRAM-Speicherzelle geht der Beschreibung der Erfindung voran.

Allgemein wird der Grabenkondensator in einem Substrat 10 gebildet. Das Substrat ist leicht mit p-Typ-Datierstoffen (p⁻), wie z.B. Bar (B), datiert. Der Graben 100 wird üblicherweise mit Polysilizium 50 gefüllt, das mit n-Dotier-stoffen (n⁺), wie z.B. Arsen (As) oder Phosphor (P), dotiert ist. Optionellerweise ist eine (nicht gezeigte) vergrabene Platte, welche beispielsweise mit As datiert ist, in dem Substrat 10 in der Umgebung des unteren Bereichs des Grabens 100 vorgesehen. Das As wird in das Siliziumsubstrat 10 von einer Datierstoffquelle, wie z.B. ASG, diffundiert, die auf den Seitenwänden des Grabens 100 gebildet wird. Das Polysilizium 50 und die vergrabene Platte bzw. das Substrat 10 dienen als die Kondensatorelektroden. Das Kondensatordielektrikum 60 trennt diese Kondensatorelektroden.

Eine den Grabenkondensator verwendende DRAM-Speicherzelle weist ebenfalls einen (nicht gezeigten) Transistor auf. Der Transistor umfaßt ein Gate sowie Diffusionsbereiche. Die Diffusionsbereiche, welche durch einen Kanal getrennt sind, werden durch Implantieren von n-Typ-Dotierstoffen, wie z.B. Phosphor (P) gebildet. Ein Kondensatoranschlußdiffusionsbereich, welcher als "Kondensatoranschluß" bezeichnet wird, verbindet den Grabenkondensator mit dem Transistor. Der Kondensatoranschlußdiffusionsbereich wird durch Ausdiffundieren von Dotierstoffen von dem Graben-Polysilizium durch eine Brücke (Plug Strap oder Buried Strap) gebildet.

Der erwähnte Kragen wird am oberen Bereich des Grabens 100 gebildet. Mit dem oberem Bereich des Grabens 100 ist der Abschnitt gemeint, welcher den Kragen enthält, und mit dem unteren Bereich des Grabens 100 ist der Abschnitt unterhalb des Kragens gemeint. Der Kragen verhindert einen Leckstrom des Kondensatoranschlusses zur vergrabenen Platte bzw. zum Substrat. Der Leckstrom ist unerwünscht, weil er die Haltezeit der Speicherzelle verschlechtert, was die Auffrischfrequenz erhöht und daher die Funktionstüchtigkeit beeinträchtigt.

Die Aktivierung des Transistors durch Anlegen geeigneter Spannungen an dem Gate und der Bitleitung schafft eine Verbindung zum Grabenkondensator. Im allgemeinen ist das Gate mit einer Wortleitung verbunden, und der Diffusionsbereich ist mit einer Bitleitung in der DRAM-Matrix über einen Kontakt verbunden. Die Bitleitung 185 ist von den Diffusionsbereichen über eine dazwischenliegende dielektrische Zwischenschicht isoliert.

Ein schmaler Isolationsgraben (STI-Isolation) wird vorgesehen, um die DRAM-Speicherzelle mit dem Grabenkondensator von anderen Speicherzellen oder sonstigen elektrischen Vorrichtungen zu isolieren.

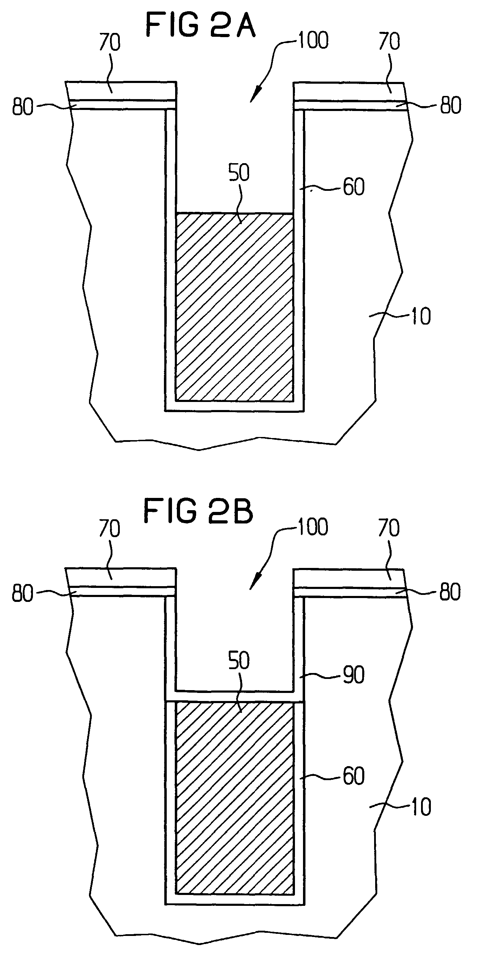

Fig. 2a-e zeigen die zum Verständnis der der Erfindung zugrundeliegenden Problematik wesentlichen Verfahrensschritte zur Herstellung des üblichen Grabenkondensators.

Mit Bezug auf Fig. 2a wird ein Unterbaustapel auf der Oberfläche des Substrats 10 gebildet. Der Unterbaustapel umfaßt mehrere verschiedene Schichten, insbesondere eine Unterbau-Nitridschicht 70 und eine Unterbau-Oxidschicht 80. Der Unterbaustapel wird unter Verwendung üblicher fotolithographischer Techniken strukturiert, um einen Bereich zu definieren, in dem der Graben 100 zu bilden ist. Ein reaktives Ionenätzen wird zum Bilden des Grabens 100 durchgeführt.

Anschließend wird eine Oxid-Nitrid-Oxid-Schicht 60 auf den Grabenwänden vorgesehen, welche als das Kondensatordielektrikum dient. Die Kondensatordielektrikumschicht 60 trennt die Kondensatorelektroden. Die Kondensatordielektrikumschicht 60 kann auch beispielsweise Nitrid oder Nitrid/Oxid anstelle von Oxid/Nitrid/Oxid oder eine sonstige dielektrische Schicht oder einen anderen Stapel von dielektrischen Schichten umfassen.

Eine Polysilizium-Halbleiterschicht 50 wird dann über dem Wafer abgeschieden, um den Graben 100 zu füllen. Amorphes Silizium ist ebenfalls verwendbar. Weitere Materialtypen, welche eine Temperaturstabilität bis zu 1050 bis 1100°C aufweisen und selektiv gegenüber Nitrid oder Oxid entfernbar sind, sind ebenfalls verwendbar.

Wie in Fig. 2a weiter gezeigt, wird das Polysilizium 50 dann bis zur Unterseite des zu bildenden Kragens entfernt. Das Entfernen des Polysiliziums 50 beinhaltet beispielsweise das Planarisieren mittels chemisch-mechanischen Polierens, ein chemisches Trockenätzen (CDE) oder ein reaktives Ionenätzen zum Bilden einer koplanaren Oberfläche mit der Oberseite des Polysiliziums in dem Graben 100. Ein reaktives Ionenätzen wird dann durchgeführt, um das Polysilizium 50 in dem Graben 100 einzusenken. Die Verwendung einer chemischen Trockenätzung zum Absenken des Polysiliziums 50 im Graben 100 ist ebenfalls möglich.

Eine dielektrische Schicht wird dann, wie in Fig. 2b gezeigt, über dem Wafer abgeschieden, welche den Unterbaustapel und die Grabenseitenwände bedeckt. Die dielektrische Schicht wird zur Bildung des Kragens verwendet. Die dielektrische Schicht ist beispielsweise aus Oxid. Bei der vorliegenden Ausführungsform wird die dielektrische Schicht durch Aufwachsen einer Schicht aus thermischem Oxid 90 und darauffolgendes Abscheiden einer Oxidschicht 110 unter Verwendung von TEOS gebildet. Das Oxid kann durch einen Temperschritt verdichtet werden. Die Oxidschicht ist hinreichend dick, um einen vertikalen Leckstrom zu vermeiden, nämlich 10-50 nm. Alternativermaßen kann die dielektrische Schicht nur eine Schicht aus thermischem Oxid aufweisen.

Bei einer anderen Ausführungsform wird die dielektrische Schicht aus CVD-Oxid gebildet. Nach der Bildung des CVD-Oxids kann ein Temperschritt zur Verdichtung des Oxids durchgeführt werden. Der Temperschritt wird beispielsweise in Ar, N₂, O₂, H₂O, N₂O, NO oder NH₃-Atmosphäre durchgeführt. Eine oxidierende Atmosphäre, wie z.B. O₂ oder H₂O kann zur Bildung einer thermischen Oxidschicht unter dem CVD-Oxid verwendet werden. Sauerstoff aus der Atmosphäre diffundiert dann durch das CVD-Oxid zum Bilden einer thermischen Oxidschicht auf der Substratoberfläche. Dies ermöglicht vorteilhafterweise die Bildung eines thermischen Oxids, falls erwünscht, ohne das Bedürfnis eines thermischen Oxidationsschritts vor der Abscheidung des CVD-Oxids. Typischerweise wird der Temperschritt bei einer Temperatur von etwa 1000-1100°C und etwa 0,5-3 Stunden lang durchgeführt.

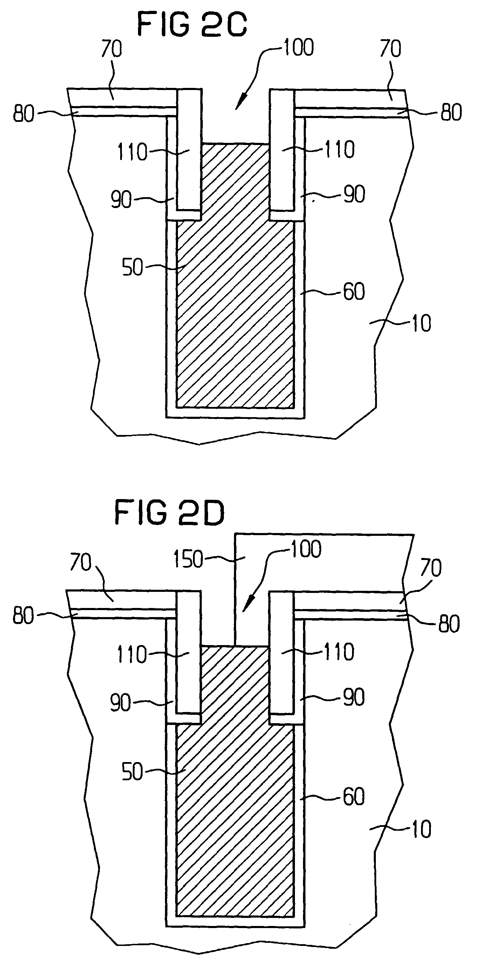

Weiter mit Bezug auf Fig. 2c wird die dielektrische Schicht beispielsweise durch reaktives Ionenätzen geätzt, um den Kragen an sich zu bilden und das Polysilizium 50 im Graben freizulegen.

Daraufhin erfolgt eine zweite Polysiliziumabscheidung zum Auffüllen des Grabens 100 und ein zweiten Rückätzen des Polysiliziums 50 auf das in Fig. 2c gezeigte Niveau.

Wie in Fig. 2d gezeigt, wird dann eine Fotolackschicht 150 aufgebracht und derart strukturiert, daß jeweils die linke Hälfte des Grabens freigelegt ist.

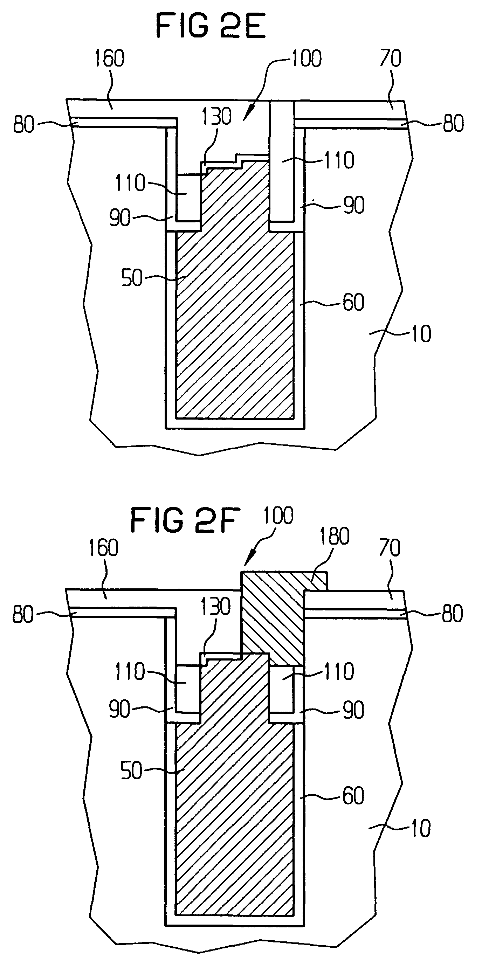

Es folgen ein an sich bekannter Isolationsgraben-Ätzschritt und ein Auffüllen und Planarisieren des Isolationsgrabens mit TEOS-Oxid 160, wobei zusätzlich ein thermisches Oxid 130 auf der Oberseite der Polysiliziumfüllung 50 gebildet wird. So gelangt man zu der in Fig. 2e gezeigten Struktur.

Anschließend wird dann in bekannter Weise, wie in Fig. 2f gezeigt, ein Kondensatoranschlußbereich 180 in der rechten Hälfte des Grabens 100 als Brücke zum Transistor bzw. einem anderen integrierten Schaltungselement gebildet. Dies wird durch eine Ätzung zum Einsenken der oberen Isolation in dem Graben und darauffolgendes Abscheiden und Strukturieren von Polysilizium erreicht. Typischerweise wird hierzu eine reaktive Ionenätzung verwendet.

Die weiteren Prozeßschritte sind im Stand der Technik wohlbekannt und werden daher hier nicht näher erläutert.

Wichtig für die vorliegende Erfindung ist, daß das Kondensatordielektrikum 60 nach dem ersten Einsenken des Polysiliziums 50 (siehe Fig. 2b) in voller Höhe des Kragens entfernt wird, der anschließend abgeschieden und strukturiert wird.

Wesentliche Nachteile dieser Vorgehensweise sind eine Desintegration der aufeinanderfolgenden Prozesse Einsenkätzung des Polysiliziums 50, Kragenoxidabscheidung und Kragenätzung. Dadurch sinkt die Prozeßgeschwindigkeit erheblich. Außerdem hinterlassen die zur Entfernung der ONO-Schicht 60 verwendeten Chemikalien Reste, welche weitere Reinigungsschritte erforderlich machen.

Die nach der Entfernung des Kondensatordielektrikums 60 durchgeführte thermische Oxidation zur Erzeugung einer stabilen Grenzfläche zwischen der Grabenseitenwand und dem Kragen führt gleichzeitig zur Bildung einer thermischen Oxidschicht auf dem ersten Polysilizium 50. Dies erschwert die Kragenätzung, da das Oxid vor der Abscheidung des zweiten Polysiliziums 50 vollständig entfernt werden muß, um die Gefahr der Bildung einer verbleibenden isolierenden Grenzfläche zwischen beiden Polysiliziumfüllungen zu vermeiden. Letzteres würde eine reduzierte Kapazität oder sogar einen Vollausfall des Kondensators bewirken.

Somit muß zur Entfernung der thermischen Oxidschicht auf dem ersten Polysilizium 50 ein zusätzlicher Naßätzschritt, vorzugsweise ein DHF-Schritt, erfolgen, der auch das Kragenoxid angreift. Somit ist wiederum die Abscheidung eines dickeren Kragenoxids notwendig, was mit einer schlechteren Prozeßkontrolle verbunden ist.

Schließlich macht dies die Einführung eines zusätzlichen Kragenoxid-Annealschritts zur Minimierung des Naßätzangriffs auf die Seitenwand des Kragens und zur Verbesserung der Gleichmäßigkeit der Kragenoxidätzung notwendig, was sich nachteilhaft auf die Prozeßzeit und die Prozeßkosten auswirkt.

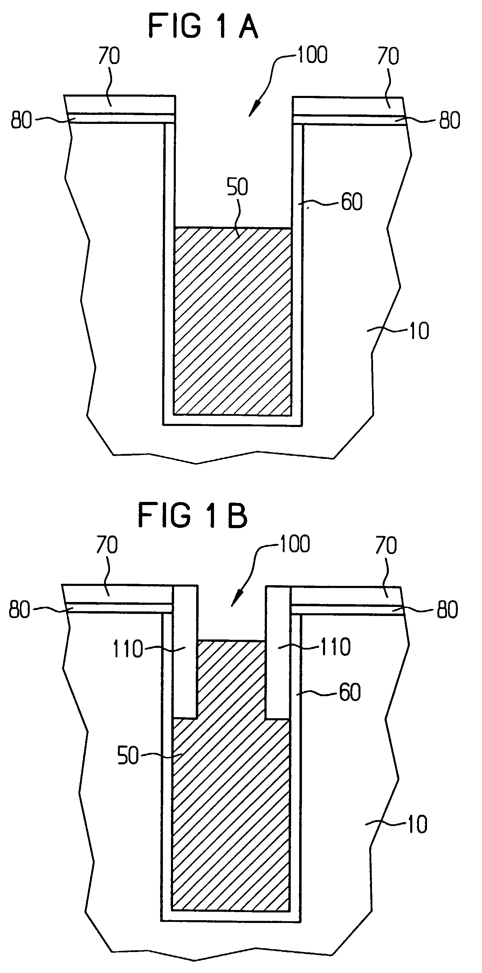

Fig. 1a-f zeigen die zum Verständnis der Erfindung wesentlichen Verfahrensschritte zur Herstellung eines Ausführungsbeispiels des erfindungsgemäßen Grabenkondensators in Analogie zu Fig. 2a-f.

Die bis zum Erreichen des in Fig. 1a gezeigten Prozeßstadiums notwendigen Schritte entsprechen denen, welche vostehend mit Bezug auf Fig. 2a erläutert wurden.

Das Entfernen des Kondensatordielektrikums in Form der OxidNitrid-Oxid-Schicht 60 in diesem Prozeßstadium entfällt jedoch bei dieser Ausführungsform der Erfindung, und anstattdessen wird der Isolationskragen 110 in Form der TEOS-Oxidschicht im oberen Teil des Grabens 100 vorgesehen.

Wie in Fig. 1b gezeigt, erfolgen dann die zweite Polysiliziumfüllung und deren Einsenken unterhalb der Substratoberfläche.

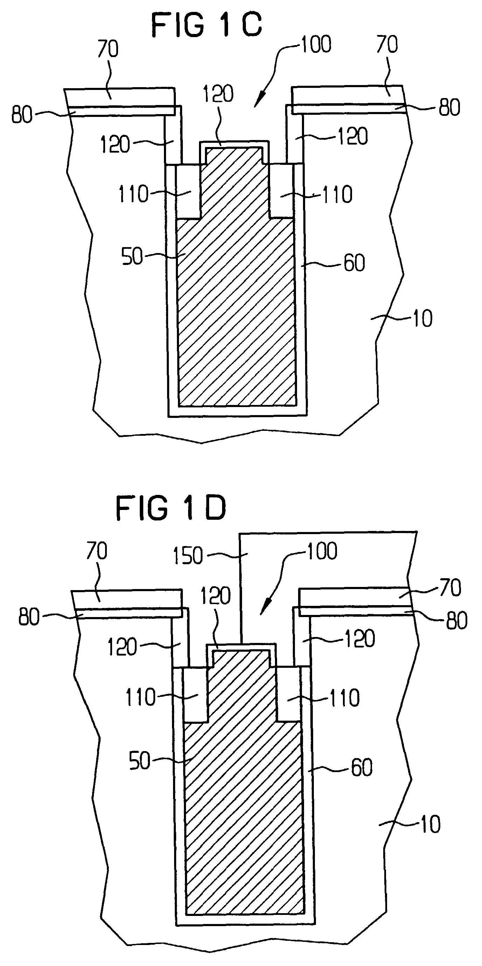

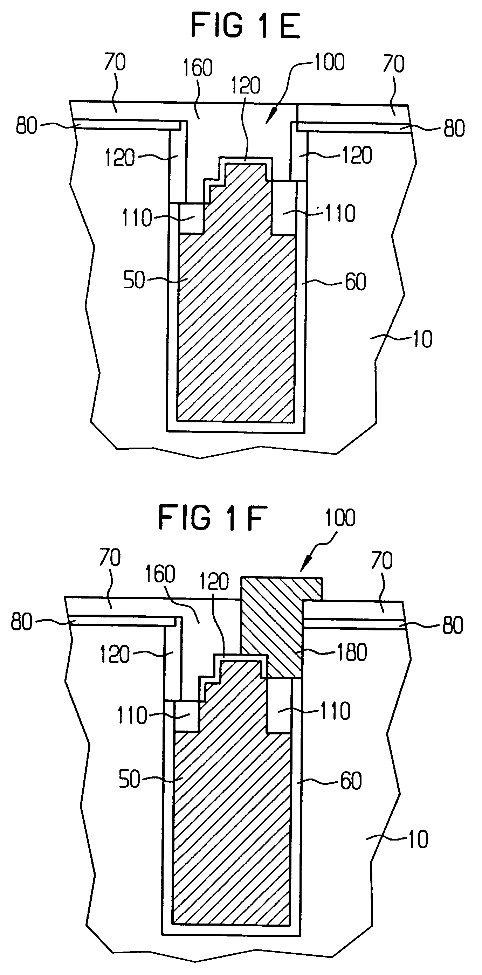

Gemäß Fig. 1c wird das Kondensatordielektrikum 60 im oberen Bereich des Grabens 100 entfernt, nachdem vorher der Isolationskragen 110 auf die gewünschte Tiefe zurückgeätzt worden ist. Diese Rückätzung kann z.B. mittels einer einfachen naßchemischen Ätzung erfolgen, beispielsweise mit BHF, wobei fast ausschließlich das Oxid geätzt wird, während das Unterbaunitrid 70 und die Polysiliziumfüllung 50 praktisch nicht angegriffen werden. Die Oxid-Nitrid-Oxid-Schicht 60 wird zweckmäßigerweise mit HF/Glyzerol oder HF/Ethylen-Glyzerol entfernt.

Danach folgen die standardmäßigen Reinigungsschritte. Zusätzlich kann noch eine dünne thermische Oxidation zur Bildung der Oxidschicht 120 erfolgen, um die Grabenseitenwand im oberen Bereich des Grabens 100 vor einer Kontamination durch Fotolack im kommenden Prozeßschritt gemäß Fig. 1d zu schützen.

In den weiteren Prozeßschritten, die in Fig. 1d-f gezeigt sind, sind im wesentlichen keine Prozeßänderungen mehr notwendig. Nach der Photolackstrukturierung gemäß Fig. 1d erfolgt eine Isolationsgrabenätzung in der linken Grabenhälfte, und nach dem Entfernen des Photolacks eine weitere thermische Oxidation, die für eine zusätzliche Versiegelung der Grabenseitenwand sorgt. Die anschließende Abscheidung eines TEOS-Oxids füllt die Lücke, die sich durch die Rückätzung des Isolationskragens ergeben hat.

Dann wird in der rechten Grabenhälfte der Kondensatoranschlußbereich 180 in dem Bereich, wo der Isolationskragen 110 entfernt worden ist und auf dem Füllmaterial im oberen Bereich des Grabens (100) gebildet, nach dem dort das Grabenoxid entfernt worden ist.

Obwohl die vorliegende Erfindung vorstehend anhand eines bevorzugten Ausführungsbeispiels beschrieben wurde, ist sie darauf nicht beschränkt, sondern auf vielfältige Art und Weise modifizierbar.

Insbesondere sind die angeführten Materialien nur beispielhaft und durch andere Materialien mit geeigneten Eigenschaften ersetzbar. Dasgleiche gilt für die genannten Ätzprozesse und Abscheidungsprozesse.

Speziell kann das Kondensatordielektrikum eine ON-, NO- eine ONO- oder eine sonstige geeignete Isolationsschicht sein.

## Patentansprüche

1. Grabenkondensator, insbesondere zur Verwendung in einer Halbleiter-Speicherzelle, mit:
- einem Graben (100), der in einem Substrat (10) gebildet ist;
- einem im Substrat (10) vorgesehenen Bereich als erste Kondensatorplatte;
- einer dielektrischen Schicht (60) auf der Grabenwand als Kondensatordielektrikum;
- einem in den Graben (100) gefüllten leitenden Füllmaterial (50) als zweite Kondensatorplatte; und
- einem Isolationskragen (110), der im oberen Bereich des Grabens (100) gebildet ist;
- wobei die dielektrische Schicht (60) den Isolationskragen (110) zumindest teilweise umgibt.

2. Grabenkondensator nach Anspruch 1, dadurch gekennzeichnet, daß die dielektrische Schicht (60) bis zur Tiefe eines im Graben (100) vorgesehenen Kondensatoranschlußbereichs (180) entfernt ist.

3. Grabenkondensator nach Anspruch 1 oder 2, dadurch gekennzeichnet, daß die dielektrische Schicht (60) bis zur Tiefe eines im Graben (100) vorgesehenen Isolationsgrabenbereichs (160) entfernt ist.

4. Grabenkondensator nach Anspruch 1, 2 oder 3, dadurch gekennzeichnet, daß die dielektrische Schicht (60) eine oder mehrere Oxid- und Nitrid-Schichten aufweist.

5. Verfahren zur Herstellung eines Grabenkondensators, insbesondere zur Verwendung in einer Halbleiter-Speicher-zelle, mit den Schritten:
- Bilden eines Grabens (100) in einem Substrat (10), welches einen Bereich aufweist, der als erste Kondensatorplatte dient;
- Bilden einer ersten dielektrischen Schicht (60) auf den Grabenwänden als Kondensatordielektrikum;
- Vorsehen eines Füllmaterials (50) im unteren Bereichs des Grabens (10) als zweite Kondensatorplatte;
- Bilden des Isolationskragens (110) im oberen Bereich des Grabens (100) auf der ersten dielektrischen Schicht (60); und
- Vorsehen des Füllmaterials (50) im oberen Bereichs des Grabens (10).

6. Verfahren nach Anspruch 5, gekennzeichnet durch den Schritt des Bildens des Isolationskragens (110) aus einer Oxidschicht.

7. Verfahren nach Anspruch 5 oder 6, gekennzeichnet durch den Schritt des selektiven Entfernen eines Teils des Isolationskragens (110) und der darunter befindlichen ersten dielektrischen Schicht (60) im oberen Bereich des Grabens (100).

8. Verfahren nach Anspruch 7, gekennzeichnet durch den Schritt des Vorsehens einer zweiten dielektischen Schicht (120) in dem Bereich, wo der Isolationskragen (110) entfernt worden ist und auf dem Füllmaterial im oberen Bereich des Grabens (100).

9. Verfahren nach Anspruch 7 oder 8, gekennzeichnet durch den Schritt des Vorsehens eines Isolationsgrabenbereichs (160) im oberen Bereich des Grabens (100) auf dem Isolationskragen (110) und gegebenenfalls der zweiten dielektischen Schicht (120).

10. Verfahren nach Anspruch 7, 8 oder 9, gekennzeichnet durch den Schritt des Vorsehens eines Kondensatoranschlußbereichs (180) in dem Bereich, wo der Isolationskragen (110) entfernt worden ist und auf dem Füllmaterial im oberen Bereich des Grabens (100).

11. Verfahren nach Anspruch 10 in Verbindung mit Anspruch 7, gekennzeichnet durch den Schritt des Vorsehens eines Isolationsgrabenbereichs (160) im oberen Bereich des Grabens (100).

12. Verfahren nach Anspruch 11, wobei bei der Bildung des Isolationsgrabenbereichs (160) Bereiche des Kondensatoranschlußbereichs entfernt werden.
